(19) Europäisches Patentamt
European Patent Office
Office européen des brevets

(11) **EP 2 510 370 B1**

(12) **EUROPÄISCHE PATENTSCHRIFT**

(45) Veröffentlichungstag und Bekanntmachung des Hinweises auf die Patenterteilung:
**31.07.2013   Patentblatt 2013/31**

(21) Anmeldenummer: **10771091.5**

(22) Anmeldetag: **25.10.2010**

(51) Int Cl.:
***G01R 31/36*** (2006.01)

(86) Internationale Anmeldenummer:
**PCT/EP2010/066054**

(87) Internationale Veröffentlichungsnummer:
**WO 2011/069741 (16.06.2011 Gazette 2011/24)**

(54) **ERMITTLUNG DES INNENWIDERSTANDS EINER BATTERIEZELLE EINER TRAKTIONSBATTERIE, DIE MIT EINEM STEUERBAREN MOTOR/GENERATOR VERBUNDEN IST**

DETERMINING THE INTERNAL RESISTANCE OF A BATTERY CELL OF A TRACTION BATTERY THAT IS CONNECTED TO A CONTROLLABLE MOTOR/GENERATOR

DÉTERMINATION DE LA RÉSISTANCE INTERNE D'UNE CELLULE D'UN ACCUMULATEUR DE TRACTION QUI EST RELIÉ À UN MOTEUR/GÉNÉRATEUR ASSERVI

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.12.2009   DE 102009054546**

(43) Veröffentlichungstag der Anmeldung:
**17.10.2012   Patentblatt 2012/42**

(73) Patentinhaber: **Robert Bosch GmbH**
**70442 Stuttgart (DE)**

(72) Erfinder: **FINK, Holger**
**70567 Stuttgart (DE)**

(56) Entgegenhaltungen:
**US-A1- 2004 076 872**

• **E-H AGLZIM ET AL: "Impedance measurement of a fuel cell on load", ELECTRICAL POWER QUALITY AND UTILISATION, 2007. EPQU 2007. 9TH INTERNATIONAL CONFERENCE ON, IEEE, PISCATAWAY, NJ, USA, 9. Oktober 2007 (2007-10-09), Seiten 1-4, XP031226030, ISBN: 978-84-690-9441-9**

EP 2 510 370 B1

**Beschreibung**

Stand der Technik

Die vorliegende Erfindung betrifft ein Verfahren und eine Vorrichtung zur Ermittlung des Innenwiderstands einer Batteriezelle einer Batterie, insbesondere einer Traktionsbatterie, gemäß den Oberbegriffen der Patentansprüche 1 und 6.

Es zeichnet sich ab, dass in Zukunft sowohl bei stationären Anwendungen, z.B. bei Windkraftanlagen, als auch in Fahrzeugen z.B. in Hybrid- und Elektrofahrzeugen, vermehrt neue Batteriesysteme zum Einsatz kommen werden. In der vorliegenden Beschreibung werden die Begriffe Batterie und Batteriesystem dem üblichen Sprachgebrauch angepasst, für Akkumulator bzw. Akkumulatorsystem verwendet.

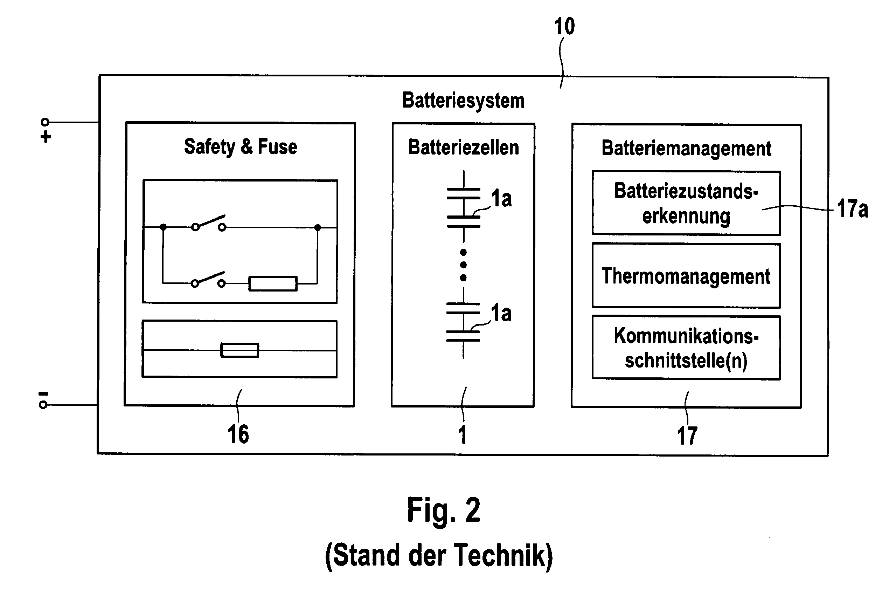

Der prinzipielle funktionale Aufbau eines Batteriesystems gemäß dem Stand der Technik ist in Figur 2 dargestellt. Um die geforderten Leistungs- und Energiedaten mit dem Batteriesystem zu erzielen, werden in einer Batteriezelle 1 einzelne Batteriezellen 1 a in Serie und teilweise zusätzlich parallel geschaltet. Zwischen den Batteriezellen 1 a und den Polen des Batteriesystems befindet sich eine sogenannte Safety&Fuse-Einheit 16, welche z.B. das Zu- und Abschalten der Batterie 1 an externe Systeme und die Absicherung des Batteriesystems gegen unzulässig hohe Ströme und Spannungen übernimmt sowie Sicherheitsfunktionen bereitstellt wie z.B. das einpolige Abtrennen der Batteriezellen 1a von den Batteriesystempolen bei Öffnen des Batteriegehäuses. Eine weitere Funktionseinheit bildet das Batteriemanagement 17, welches neben der Batteriezustandserkennung 17a auch die Kommunikation mit anderen Systemen sowie das Thermomanagement der Batterie 1 durchführt.

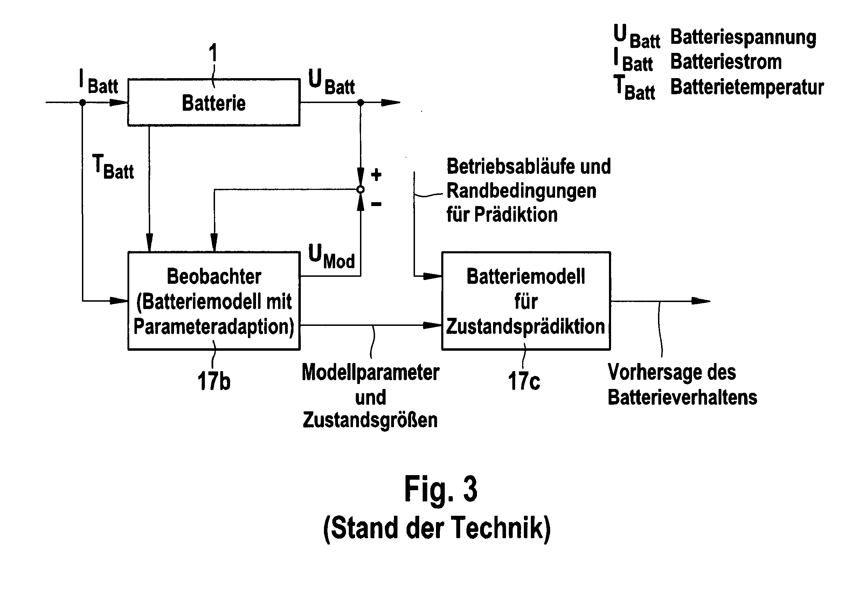

Die in Figur 2 dargestellte Funktionseinheit Batteriezustandserkennung 17a hat die Aufgabe, den aktuellen Zustand der Batterie 1 zu bestimmen sowie das künftige Verhalten der Batterie 1 vorherzusagen, z.B. eine Lebensdauervorhersage und/oder eine Reichweitenvorhersage. Die Vorhersage des künftigen Verhaltens wird auch als Prädiktion bezeichnet. Der prinzipielle Aufbau einer modellbasierten Batteriezustandserkennung ist in Figur 3 dargestellt. Die dargestellte modellbasierte Batteriezustandserkennung und -prädiktion basiert auf einer Auswertung der elektrischen Größen Batteriestrom und -spannung sowie der Temperatur der Batterie 1 mittels eines Beobachters 17b und eines Batteriemodells 17c in bekannter Weise. Die Batteriezustandserkennung kann für einzelne Zellen 1 a einer Batterie 1 erfolgen, wobei dies dann auf Basis der entsprechenden Zellspannung, des Zellstroms sowie der Zelltemperatur erfolgt. Weiter kann die Batteriezustandserkennung auch für die gesamte Batterie 1 erfolgen. Dies erfolgt dann - je nach Anspruch an die Genauigkeit - entweder durch Auswertung der Zustände der einzelnen Zellen 1 a der Batterie 1 und einer darauf basierenden Aggregation für die gesamte Batterie 1 oder direkt durch Auswertung der gesamten Batteriespannung, des Batteriestroms und der Batterietemperatur. Allen Verfahren gemäß Stand der Technik ist dabei gemein, dass die im normalen Betrieb der Batterie 1 auftretenden Strom-, Spannungs- und Temperaturverläufe für die Ermittlung des Batteriezustands sowie für die Prädiktion des künftigen Verhaltens herangezogen werden.

Aufgabe der vorliegenden Erfindung ist, ein neues Konzept für die Ermittlung des Innenwiderstands der Einzelzellen eines Batteriesystems vorzustellen, mit dem die Batteriezustandserkennung und -prädiktion gegenüber dem heutigen Stand der Technik robuster, genauer und unabhängig vom Betriebszustand der Batterie realisiert werden kann.

Offenbarung der Erfindung

Das erfindungsgemäße Verfahren mit den Merkmalen des Patentanspruchs 1 und die erfindungsgemäße Vorrichtung mit den Merkmalen des Patentanspruchs 6 weisen demgegenüber den Vorteil auf, dass sie zur Bestimmung des Innenwiderstands von Batteriezellen bei Batteriesystemen, die im Systemverbund mit einem elektrischen Antrieb betrieben werden, ohne oder mit lediglich geringem zusätzlichen elektronischen Schaltungsaufwand zum Einsatz kommen können. Dieses Verfahren und diese Vorrichtung haben gegenüber dem heutigen Stand der Technik den Vorteil, dass zur Bestimmung des Innenwiderstands immer wieder der gleiche Betriebablauf herbeigeführt werden kann und dadurch eine besonders robuste und genaue Bestimmung möglich wird. Dies ist bei den aktuell bekannten Verfahren nicht möglich.

Die Unteransprüche zeigen bevorzugte Weiterbildungen der Erfindung.

Besonders bevorzugt umfasst das erfindungsgemäße Verfahren, dass die Modulation des Magnetfeld bildenden Anteils des Motors/Generators erfolgt, wenn sich den Motor/Generator in einem Leerlaufzustand befindet.

Weiter oder alternativ umfasst das erfindungsgemäße Verfahren, dass zur Modulation des Magnetfelds bildenden Anteils des Motors/Generators die Magnetisierung des Motors/Generators erhöht und/oder verringert wird.

Das erfindungsgemäße Verfahren umfasst alternativ oder zusätzlich den Schritt der Ermittlung einer alterungsabhängigen Erhöhung des Innenwiderstands der Batteriezelle anhand einer bekannten Abhängigkeit des Innenwiderstands von einer während der Bestimmung des Innenwiderstands bestehenden Zellentemperatur und einem während der Bestimmung des Innenwiderstands bestehenden Ladezustand der Batteriezelle. Die korrespondierende bevorzugte Weiterbildung der erfindungsgemäßen Vorrichtung umfasst hierfür bevorzugt eine Tabelle, die eine Abhängigkeit des Innenwiderstands von einer während der Bestimmung des Innenwiderstands bestehenden Zellentemperatur und einem während der Bestimmung des Innenwiderstands bestehenden Ladezustand der Batteriezelle speichert, und eine Auswerteeinheit, die eine alterungsabhängige Erhöhung des Innenwiderstands der Batteriezelle anhand des ermittelten Innenwiderstands und einer Abfrage der Tabelle bestimmt. Alternativ zu der Tabelle kann eine zweite Recheneinheit vorgesehen sein, die die Abhängigkeit des Innenwiderstands von der während der Bestimmung des Innenwiderstands bestehenden Zellentemperatur und dem während der Bestimmung des Innenwiderstands bestehenden Ladezustand der Batteriezelle anhand einer oder mehrerer mathematischer Gleichung(en) wiedergibt.

Weiter umfassen das erfindungsgemäße Verfahren und die erfindungsgemäße Vorrichtung zusätzlich oder alternativ bevorzugt, dass der Motor/Generator eine vorzugsweise über einen Pulswechselrichter betriebene Drehfeldmaschine ist.

Zeichnung

Nachfolgend wird ein Ausführungsbeispiel der Erfindung unter Bezugnahme auf die begleitende Zeichnung im Detail beschrieben. In der Zeichnung zeigen:

Figur 1    ein Prinzipschaltbild einer ersten bevorzugten Ausführungsform einer erfindungsgemäßen Vorrichtung zur Ermittlung des Innenwiderstands einer Batteriezelle,

Figur 2    einen funktionalen Aufbau eines Batteriesystems gemäß dem Stand der Technik, und

Figur 3    ein Prinzipschaltbild einer modellbasierten Batteriezustandserkennung und -prädiktion nach dem Stand der Technik.

Bevorzugte Ausführungsform der Erfindung

Nachfolgend wird unter Bezugnahme auf die Figuren eine bevorzugte Ausführungsform der Erfindung im Detail beschrieben.

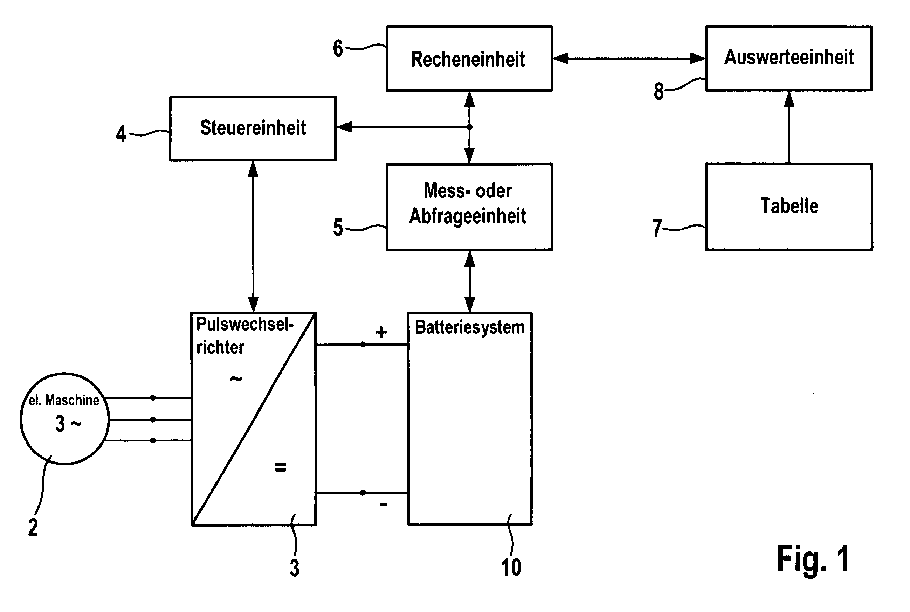

In Figur 1 ist eine bevorzugte Ausführungsform der erfindungsgemäßen Vorrichtung dargestellt.

Diese umfasst einen elektrischen Antrieb 2, welcher aus einem Batteriesystem 10 gespeist wird. Bei der elektrischen Maschine 2 handelt es sich um eine Drehfeldmaschine (z.B. eine Asynchron- oder eine Synchronmaschine). Die Maschine 2 ist über einen Pulswechselrichter 3 an das Batteriesystem 10 angebunden. Mit Hilfe des Pulswechselrichters 3 kann sowohl ein Leistungsfluss von der Batterie 1 des Batteriesystems 10 in die elektrische Maschine 2 (der Pulswechselrichter 3 arbeitet dann als Wechselrichter, die elektrische Maschine 2 wird motorisch betrieben) als auch in umgekehrter Richtung von der elektrischen Maschine 2 in die Batterie 1 (der Pulswechselrichter 3 arbeitet dann als Gleichrichter, die elektrische Maschine 2 wird generatorisch betrieben) erzeugt werden.

Im Industriebereich ist für den Betrieb von Drehfeldmaschinen bei Einsatz von Pulswechselrichtem heute die Anwendung einer sogenannten feldorientierten Maschinenführung Stand der Technik. Die Regelung der Maschinenströme erfolgt dabei in einem Koordinatensystem, welches mit dem Magnetfeld der Maschine mitrotiert. Auf diese Weise gelingt es, die Maschinenströme in einen sogenannten (Magnet-) Feld bildenden Anteil und in einen Drehmoment bildenden Anteil aufzuteilen. In einem Betriebszustand, in dem die Maschine kein Drehmoment an ihrer Welle abgibt (Leerlauf bei beliebiger Drehzahl), kann der Feld bildende Anteil des Maschinenstroms verändert werden, ohne dass dadurch Drehmoment an der Welle aufgebaut wird. Das im Folgenden beschriebene erfindungsgemäße Verfahren zur Bestimmung des Innenwiderstands der Batteriezellen basiert darauf, den Feld bildenden Anteil der Drehfeldmaschine zu modulieren.

Ausgangspunkt für die Erläuterung des erfindungsgemäßen Verfahrens sei ein Betriebszustand bei dem die elektrische Maschine 2 kein Drehmoment an ihrer Welle abgibt und das Batteriesystem 10 über die Leistungsschalter der Safety&Fuse- Einheit 16 an das Traktionsbordnetz des Fahrzeugs zugeschaltet ist. Dann wird die Bestimmung des Innenwiderstands der Batteriezellen erfindungsgemäß wie folgt realisiert: Nach einem Auslösen eines Betriebsmodus "Innenwiderstand bestimmen" an der Steuereinheit 4 moduliert diese daraufhin den Feld bildenden Anteil des Maschinenstroms derart, dass die Maschine 2 weiterhin kein Drehmoment an der Welle abgibt, allerdings bei sich ändernder Magnetisierung. Zur Erhöhung der Magnetisierung ist ein Leistungsfluss von der Batterie 1 in die elektrische Maschine 2 erforderlich. Umgekehrt ergibt sich bei Verringerung der Magnetisierung ein Leistungsfluss von der elektrischen Maschine 2 in die Batterie 1. Durch Überlagerung eines Wechselanteils zu der im Normalbetrieb der elektrischen Maschine 2 gewünschten Magnetisierung kann erreicht werden, dass der Batterie 1 ein Wechselstrom (Laden und Entladen der Batterie) eingeprägt wird. Mit einem Wechselstrom wird in den Batteriezellen 1 a ein Spannungsabfall an deren ohmschem Innenwiderstand hervorgerufen. Bei Lithium-Ionen-Batterien für den Einsatz in Hybrid- oder Elektrofahrzeugen wird eine Erfassung der Spannungen aller Batteriezellen durchgeführt, um eine Symmetrierung des Ladezustands sowie eine Überwachung der Einhaltung der zulässigen Spannungsgrenzwerte durchführen zu können. Für die Durchführung der Batteriezustandserkennung wird der Batteriestrom erfasst. Somit stehen in dem Batteriesystem die erforderlichen Informationen bereit, die von einer mit der Steuereinheit 4 verbundenen Mess- oder Abfrageeinheit 5 erfasst werden, um bei der oben beschriebenen Anregung der Batteriezellen die Innenwiderstände durch eine Recheneinheit 6, die mit der Steuereinheit 4 und der Mess- und Abfrageeinheit 5 verbunden ist, z.B. gemäß der Beziehung

$$R_{i\_n}\left(Temp, SOC, Alterung\right) = \frac{\Delta U_n}{\Delta I} \qquad (1)$$

zu ermitteln (n sei dabei die Laufvariable für die Zellen des Batteriesystems).

Anstelle der Erfassung der Spannungen aller Batteriezellen und des Batteriestroms über das Batteriemanagement 17 kann die Mess- oder Abfrageeinheit 5 diese Größen auch direkt erfassen.

Bei bekannter Abhängigkeit des Innenwiderstands von der Zelltemperatur und dem Ladezustand der Zelle, kann die alterungsabhängige Erhöhung des Innenwiderstands der Batteriezelle ermittelt werden. Hierzu ist die Recheneinheit 6 mit einer Auswerteeinheit 8 verbunden, die die alterungsabhängige Erhöhung des Innenwiderstands der Batteriezelle 1a (n) anhand des ermittelten Innenwiderstands und eine Abfrage einer Tabelle 7 bestimmt, die die Abhängigkeit des Innenwiderstands von der während der Bestimmung des Innenwiderstands bestehenden Zelltemperatur und einem während der Bestimmung des Innenwiderstands bestehenden Ladezustand der Batteriezelle 1 a speichert. Alternativ zur Abfrage der Tabelle 7 kann eine zweite Recheneinheit angefragt werden, die die Abhängigkeit des Innenwiderstands von der Zelltemperatur und des Ladezustands anhand mathematischer Gleichungen abbildet. Das vorgestellte erfindungsgemäße Verfahren zur Bestimmung des Innenwiderstands kann z.B. auch bei abgestelltem Fahrzeug durchgeführt werden. Dadurch wird die Bestimmung des Innenwiderstands nicht durch den überlagerten "Normalbetrieb" der Batterie 1 negativ beeinflusst. Dies stellt einen wesentlichen Vorteil gegenüber den bisher bekannten Verfahren dar.

Mit dem vorgestellten Verfahren zur Ermittlung des Innenwiderstands der Batterie kann eine der wesentlichen Informationen, die für eine Batteriezustandserkennung und -prädiktion erforderlich sind - die temperatur-, ladezustands- und alterungsabhängige Änderung des Innenwiderstands der Batteriezellen - auch in Betriebszuständen ermittelt werden, in denen sich der Batteriestrom im "Normalbetrieb" nicht nennenswert ändert. Bei den bisher bekannten Verfahren kann der Innenwiderstand nur in Betriebsphasen ermittelt werden, bei denen der Batteriestrom sich während des "Normalbetriebs" nennenswert ändert. Auf diese Weise gelingt es, die Ermittlung des Innenwiderstands der Batteriezellen gegenüber dem Stand der Technik wesentlich robuster und genauer durchzuführen.

Neben der obigen schriftlichen Offenbarung wird hier ausdrücklich auf die Offenbarung in den Figuren verwiesen.

## Patentansprüche

1. Verfahren zur Ermittlung des Innenwiderstands einer Batteriezelle (1a) einer Batterie (1), insbesondere einer Traktionsbatterie, wobei die Batterie (1) derart mit einem steuerbaren Motor/Generator (2) verbunden ist, dass ein Energiefluss von der Batterie (1) zu dem Motor/Generator (2) oder von dem Motor/Generator (2) zu der Batterie (1) erfolgen kann, mit den folgenden Schritten:

   - Modulieren des Magnetfeld bildenden Anteils des stroms des Motors/Generators (2), wobei zur Modulation des Magnetfeld bildenden Anteils des Stroms des Motors/Generators (2) die Magnetisierung des Motors/Generators (2) erhöht und/oder verringert wird,
   - Bestimmen einer Spannungsänderung an der Batteriezelle (1a) und einer Änderung des Stromflusses durch die Batteriezelle (1a) während der Modulation des Magnetfeld bildenden Anteils des Stroms des Motors/Generators (2), und
   - Berechnen des Innenwiderstands der Batteriezelle (1a) als den Quotienten der Spannungsänderung und der Stromflussänderung.

2. Verfahren nach Anspruch 1, **dadurch gekennzeichnet, dass** die Modulation des Magnetfeld bildenden Anteils des Stroms des Motors/Generators (2) erfolgt, wenn sich der Motor/Generator (2) in einem Leerlaufzustand befindet.

3. Verfahren nach einem der Ansprüche 1 bis 2, **gekennzeichnet durch** den Schritt der Ermittlung einer alterüngsabhängigen Erhöhung des Innenwiderstands der Batteriezelle (1a) anhand einer bekannten Abhängigkeit des Innenwiderstands von einer während der Bestimmung des Innenwiderstands bestehenden Zellentemperatur und einem während der Bestimmung des Innenwiderstands bestehenden Ladezustand der Batteriezelle (1a).

**4.** Verfahren nach einem der Ansprüche 1 bis 3, **dadurch gekennzeichnet, dass** der Motor/Generator (2) eine vorzugsweise über einen Pulswechselrichter (3) betriebene Drehfeldmaschine ist.

**5.** Vorrichtung zur Ermittlung des Innenwiderstands einer Batteriezelle (1a) einer Batterie (1), insbesondere einer Traktionsbatterie, wobei die Batterie (1) derart mit einem steuerbaren Motor/Generator (2) verbunden ist, dass ein Energiefluss von der Batterie (1) zu dem Motor/Generator (2) oder von dem Motor/Generator (2) zu der Batterie (1) erfolgen kann, mit:

- einer Steuereinheit (4) zum Modulieren des Magnetfeld bildenden Anteils des Stroms des Motors/Generators (2), wobei zur Modulation des Magnetfeld bildenden Anteils des Stroms des Motors/Generators (2) die Steuereinheit zum Erhöhen und/oder Verringern der Magnetisierung des Motors/Generators (2) eingerichtet ist
- einer Mess- oder Abfrageeinheit (5) zum Bestimmen einer Spannungsänderung an der Batteriezelle (1a) und einer Änderung des Stromflusses durch die Batteriezelle (1a) während der Modulation des Magnetfeld bildenden Anteils des Stroms des Motors/Generators (2), und
- einer Recheneinheit (6) zum Berechnen des Innenwiderstands der Batteriezelle (1a) als den Quotienten der Spannungsänderung und der Stromflussänderung.

**6.** Vorrichtung nach Anspruch 5, **gekennzeichnet durch**

- eine Tabelle (7), die eine Abhängigkeit des Innenwiderstands von einer während der Bestimmung des Innenwiderstands bestehenden Zellentemperatur und einem während der Bestimmung des Innenwiderstands bestehenden Ladezustand der Batteriezelle (1a) speichert, und
- eine Auswerteeinheit (8), die eine alterungsabhängige Erhöhung des Innenwiderstands der Batteriezelle (1a) anhand des ermittelten Innenwiderstands und einer Abfrage der Tabelle (7) bestimmt.

**7.** Vorrichtung nach Anspruch 5 oder 6, **dadurch gekennzeichnet, dass** der Motor/Generator (2) eine vorzugsweise über einen Pulswechselrichter betriebene Drehfeldmaschine ist.

**Claims**

**1.** Method for determining the internal resistance of a battery cell (1a) of a battery (1), in particular a traction battery, wherein the battery (1) is connected to a controllable motor/generator (2) in such a way that energy can flow from the battery (1) to the motor/generator (2) or from the motor/generator (2) to the battery (1), comprising the following steps:

- modulating the magnetic-field-forming portion of the current of the motor/generator (2), wherein the magnetization of the motor/generator (2) is increased and/or reduced in order to modulate the magnetic-field-forming portion of the current of the motor/generator (2),
- determining a change in voltage across the battery cell (1a) and a change in the current flow through the battery cell (1a) during the modulation of the magnetic-field-forming portion of the current of the motor/generator (2), and
- calculating the internal resistance of the battery cell (1a) as the quotient of the change in voltage and the change in current flow.

**2.** Method according to Claim 1, **characterized in that** the magnetic-field-forming portion of the current of the motor/generator (2) is modulated when the motor/generator (2) is in an idling state.

**3.** Method according to either of Claims 1 and 2, **characterized by** the step of determining an age-dependent increase in the internal resistance of the battery cell (1a) on the basis of a known dependence of the internal resistance on a cell temperature which exists during the determination of the internal resistance and on a state of charge of the battery cell (1a) which exists during the determination of the internal resistance.

**4.** Method according to one of Claims 1 to 3, **characterized in that** the motor/generator (2) is a three-phase machine which is preferably operated by means of a pulse-controlled inverter (3).

**5.** Apparatus for determining the internal resistance of a battery cell (1a) of a battery (1), in particular a traction battery, wherein the battery (1) is connected to a controllable motor/generator (2) in such a way that energy can flow from the battery (1) to the motor/generator (2) or from the motor/generator (2) to the battery (1), comprising:

- a control unit (4) for modulating the magnetic-field-forming portion of the current of the motor/generator (2), wherein the control unit is designed to increase and/or reduce the magnetization of the motor/generator (2) in order to modulate the magnetic-field-forming portion of the current of the motor/generator (2),
- a measurement or checking unit (5) for determining a change in voltage across the battery cell (1a) and a change in current flow through the battery cell (1a) during the modulation of the magnetic-field-forming portion of the current of the motor/generator (2), and
- a computer unit (6) for calculating the internal resistance of the battery cell (1a) as the quotient of the change in voltage and the change in current flow.

**6.** Apparatus according to Claim 5, **characterized by**

- a table (7) which stores a dependence of the internal resistance on a cell temperature which exists during the determination of the internal resistance and on a state of charge of the battery cell (1a) which exists during the determination of the internal resistance, and
- an evaluation unit (8) which determines an age-dependent increase in the internal resistance of the battery cell (1a) on the basis of the determined internal resistance and a check of the table (7).

**7.** Apparatus according to Claim 5 or 6, **characterized in that** the motor/generator (2) is a three-phase machine which is preferably operated by means of a pulse-controlled inverter.

## Revendications

**1.** Procédé de détermination de la résistance interne d'une cellule (1a) d'une batterie (1), en particulier d'une batterie de traction, dans lequel la batterie (1) est reliée à un moteur-générateur (2) asservi de telle sorte que de l'énergie puisse être transférée de la batterie (1) au moteur-générateur (2) ou du moteur-générateur (2) à la batterie (1), le procédé présentant les étapes suivantes :

modulation de la partie du courant du moteur-générateur (2) qui forme le champ magnétique, la partie du courant du moteur-générateur (2) qui forme la magnétisation du moteur-générateur (2) étant augmentée et/ou diminuée pour moduler le champ magnétique,
détermination d'une modification de la tension aux bornes de la cellule (1a) de la batterie et de la modification du courant qui traverse la cellule (1a) de la batterie pendant la modulation de la partie du courant du moteur-générateur (2) qui forme le champ magnétique et
calcul de la résistance interne de la cellule (1a) de la batterie en tant que quotient entre la modification de la tension et la modification du courant.

**2.** Procédé selon la revendication 1, **caractérisé en ce que** la modulation de la partie du courant du moteur-générateur (2) qui forme le champ magnétique a lieu lorsque le moteur-générateur (2) fonctionne à vide.

**3.** Procédé selon l'une des revendications 1 et 2, **caractérisé par** l'étape consistant à déterminer une augmentation de la résistance interne de la cellule (1a) de la batterie suite au vieillissement, à l'aide d'une dépendance connue de la résistance interne vis-à-vis de la température de la cellule qui prévaut pendant la détermination de la résistance interne et de l'état de charge de la cellule (1a) de la batterie qui prévaut lors de la détermination de la résistance interne.

**4.** Procédé selon l'une des revendications 1 à 3, **caractérisé en ce que** le moteur-générateur (2) est de préférence une machine à champ tournant alimentée par un redresseur (3) à impulsions.

**5.** Dispositif de détermination de la résistance interne d'une cellule (1a) d'une batterie (1), en particulier d'une batterie de traction, la batterie (1) étant raccordée à un moteur-générateur (2) asservi de telle sorte que de l'énergie puisse être transférée de la batterie (1) au moteur-générateur (2) ou du moteur-générateur (2) à la batterie (1), le dispositif présentant :

une unité de commande (4) qui module la partie du courant du moteur-générateur (2) qui forme le courant magnétique, l'unité de commande étant conçue pour augmenter et/ou diminuer la magnétisation du moteur-générateur (2) pour moduler la partie du courant du moteur-générateur (2) qui forme le champ magnétique, une unité (5) de mesure ou d'interrogation qui détermine la modification de tension aux bornes de la cellule (1a) de la batterie et une modification du courant qui traverse la cellule (1a) de la batterie pendant la modulation de la partie du courant du moteur-générateur (2) qui forme le champ magnétique et une unité de calcul (6) qui calcule la résistance interne de la cellule (1a) de la batterie en tant de quotient entre la modification de la tension et la modification du courant.

6. Dispositif selon la revendication 5, **caractérisé par** un tableau (7) qui conserve la dépendance de la résistance interne vis-à-vis de la température de la cellule qui prévaut pendant la détermination de la résistance interne et l'état de charge de la cellule (1a) de la batterie qui prévaut pendant la détermination de la résistance interne et une unité d'évaluation (8) qui détermine l'augmentation de la résistance interne de la cellule (1a) de la batterie en fonction de son vieillissement, à l'aide de la résistance interne déterminée et d'une consultation du tableau (7).

7. Dispositif selon les revendications 5 ou 6, **caractérisé en ce que** le moteur-générateur (2) est une machine à champ tournant alimentée de préférence par un redresseur à impulsions.

**Fig. 1**

Auswerteeinheit — 8

Tabelle — 7

Recheneinheit — 6

Mess- oder Abfrageeinheit — 5

Steuereinheit — 4

Batteriesystem — 10

+   −

Pulswechsel-richter — 3

≈   =

el. Maschine 3~ — 2

**Fig. 2**

**(Stand der Technik)**

EP 2 510 370 B1

$U_{Batt}$   Batteriespannung
$I_{Batt}$   Batteriestrom
$T_{Batt}$   Batterietemperatur

Fig. 3
(Stand der Technik)